# FASCICULE DE BREVET EUROPEEN

(11) **EP 3 646 681 B1**
(45) Date de publication et mention de la délivrance du brevet: **21.08.2024**
(21) Numéro de dépôt: 18730412.6
(22) Date de dépôt: 30.05.2018
(51) Int. Cl.: H05K 7/14, H02M 7/00

(54) **CONVERTISSEUR DE TENSION, PROCÉDÉ DE FABRICATION D'UN TEL CONVERTISSEUR DE TENSION ET ENSEMBLE D'UN MODULE PRINCIPAL ET D'UN MODULE BORNIER POUR FORMER UN TEL CONVERTISSEUR DE TENSION**
SPANNUNGSWANDLER, VERFAHREN ZUR HERSTELLUNG SOLCH EINES SPANNUNGSWANDLERS UND ANORDNUNG EINES HAUPTMODULS UND EINES ANSCHLUSSBLOCKMODULS ZUR AUSBILDUNG SOLCH EINES SPANNUNGSWANDLERS
VOLTAGE CONVERTER, METHOD FOR MANUFACTURING SUCH A VOLTAGE CONVERTER AND ASSEMBLY OF A MAIN MODULE AND A TERMINAL BLOCK MODULE FOR FORMING SUCH A VOLTAGE CONVERTER

(30) Priorité: 28.06.2017 FR 1755946
(43) Date de publication de la demande: 06.05.2020
(73) Titulaire: Valeo Electrification, 95800 Cergy (FR)
(72) Inventeur: FALGUIER, Manuel, 94046 Creteil cedex (FR); HENNEGUET, Romain, 94046 Creteil cedex (FR); BODIN, Ludovic, 94046 Creteil cedex (FR); BERTRAND, Mathieu, 94046 Creteil cedex (FR)
(74) Mandataire: Valeo Powertrain Systems
(86) Numéro de dépôt international: PCT/FR2018/051247
(87) Numéro de publication internationale: WO 2019/002710

(56) Documents cités:
- EP-A1- 2 244 358
- WO-A2-2015/033062
- DE-T5- 112015 002 670
- JP-A- H07 245 968
- US-A1- 2004 257 841
- US-A1- 2016 172 111

## Description

### DOMAINE TECHNIQUE

La présente invention concerne un convertisseur de tension, un procédé de fabrication d'un tel convertisseur de tension et un ensemble d'un module principal et d'un module bornier pour former un tel convertisseur de tension.

### ARRIÈRE-PLAN TECHNOLOGIQUE

On connaît de l'état de la technique un convertisseur de tension comportant :
- une barre omnibus positive principale,
- une barre omnibus négative principale,
- au moins une barre omnibus de phase destinée à être connectée à une phase respective d'une machine électrique,
- pour chaque barre omnibus de phase :
   - un interrupteur de côté haut connecté entre la barre omnibus positive principale et la barre omnibus de phase,
   - un interrupteur de côté bas connecté entre la barre omnibus de phase et la barre omnibus négative principale,
   - une masse électrique,
- un premier condensateur connecté entre à la barre omnibus positive principale et la masse électrique,
- un deuxième condensateur connecté entre la barre omnibus négative principale et la masse électrique, la barre omnibus positive principale présentant une borne positive et la barre omnibus négative principale présentant une borne négative.

Les bornes positive et négative sont destinées à être connectées à une alimentation électrique. Or, suivant l'environnement du convertisseur de tension, c'est-à-dire en particulier la configuration de l'alimentation électrique et les exigences de compatibilité électromagnétique, la forme et/ou le positionnement des bornes positive et négative peut varier. Ainsi, pour chaque nouvel environnement, il est nécessaire de concevoir à nouveau les barres omnibus positive et négative principales, ce qui génère des coûts importants de recherche et développement et de configuration des outils de fabrication.

L'invention a pour but de proposer un convertisseur de tension simplifiant son adaptation à son environnement.

### RÉSUMÉ DE L'INVENTION

À cet effet, il est proposé un convertisseur de tension comportant :
- un module principal comportant :
   - une barre omnibus positive principale,
   - une barre omnibus négative principale,
   - au moins une barre omnibus de phase destinée à être connectée à une phase respective d'une machine électrique,
   - pour chaque barre omnibus de phase :
      - un interrupteur de côté haut connecté entre la barre omnibus positive principale et la barre omnibus de phase,
      - un interrupteur de côté bas connecté entre la barre omnibus de phase et la barre omnibus négative principale,
   - une masse électrique,
   - un premier condensateur connecté entre à la barre omnibus positive principale et la masse électrique,
   - un deuxième condensateur connecté entre la barre omnibus négative principale et la masse électrique,
- un module bornier assemblé au module principal et comportant :
   - une barre omnibus positive auxiliaire présentant une borne positive, la barre omnibus positive auxiliaire étant connectée à la barre omnibus positive principale,
   - une barre omnibus négative auxiliaire présentant une borne négative, la barre omnibus négative auxiliaire étant connectée à la barre omnibus négative principale.

Grâce à l'invention, seul le module bornier a besoin d'être conçu à nouveau pour chaque nouvel environnement. ce qui réduit les coûts de fabrication du convertisseur de tension.

En outre, la présence des premier et deuxième condensateurs permet d'assurer une compatibilité électromagnétique minimale, c'est-à-dire par exemple de classe 0/1 (selon la norme CISPR25), qui peut être complétée, sans changer le module principal, en ajoutant des composants de filtrage électromagnétique dans le module bornier.

De façon optionnelle, le module bornier comporte en outre un tore magnétique entourant la barre omnibus positive auxiliaire et la barre omnibus positive auxiliaire.

De façon optionnelle également, le module bornier comporte en outre un troisième condensateur connecté entre la barre omnibus positive auxiliaire et la barre omnibus négative auxiliaire.

De façon optionnelle également, le module bornier comporte en outre :
- un quatrième condensateur connecté entre à la barre omnibus positive auxiliaire et la masse électrique,
- un cinquième condensateur connecté entre la barre omnibus négative auxiliaire et la masse électrique.

Avantageusement, l'ajout ou pas d'un tore magnétique et/ou d'un troisième, quatrième ou cinquième condensateur permet d'obtenir différentes classes de compatibilité électromagnétique pour une même architecture du bornier.

Il est également proposé un procédé de fabrication d'un convertisseur de tension selon l'invention, comportant :
- l'obtention d'un module principal comportant :
   - une barre omnibus positive principale,
   - une barre omnibus négative principale,
   - au moins une barre omnibus de phase destinée à être connectée à une phase respective d'une machine électrique,
   - pour chaque barre omnibus de phase :
      - un interrupteur de côté haut connecté entre la barre omnibus positive principale et la barre omnibus de phase,
      - un interrupteur de côté bas connecté entre la barre omnibus de phase et la barre omnibus négative principale,
   - une masse électrique,
   - un premier condensateur connecté entre à la barre omnibus positive principale et la masse électrique,
   - un deuxième condensateur connecté entre la barre omnibus négative principale et la masse électrique,
- l'obtention d'un module auxiliaire comportant :
   - une barre omnibus positive auxiliaire présentant une borne positive,
   - une barre omnibus négative auxiliaire présentant une borne négative,
- l'assemblage du module auxiliaire au module principal, cet assemblage comportant la connexion de la barre omnibus positive auxiliaire à la barre omnibus positive principale et de la barre omnibus négative auxiliaire fixée à la barre omnibus négative principale.

Il est également proposé l'ensemble d'un module principal et d'un module bornier destinés à être assemblés l'un à l'autre, le module principal comportant :
- une barre omnibus positive principale,
- une barre omnibus négative principale,
- au moins une barre omnibus de phase destinée à être connectée à une phase respective d'une machine électrique,
- pour chaque barre omnibus de phase :
   - un interrupteur de côté haut connecté entre la barre omnibus positive principale et la barre omnibus de phase,
   - un interrupteur de côté bas connecté entre la barre omnibus de phase et la barre omnibus négative principale,
- une masse électrique,
- un premier condensateur connecté entre à la barre omnibus positive principale et la masse électrique,
- un deuxième condensateur connecté entre la barre omnibus négative principale et la masse électrique,
et le module bornier comportant :
- une barre omnibus positive auxiliaire présentant une borne positive, la barre omnibus positive auxiliaire étant destinée à être connectée à la barre omnibus positive principale lors de l'assemblage du module bornier au module principal,
- une barre omnibus négative auxiliaire présentant une borne négative, la barre omnibus négative auxiliaire étant destinée à être connectée à la barre omnibus négative principale lors de l'assemblage du module bornier au module principal.

De façon optionnelle, le module bornier comporte en outre un tore magnétique entourant la barre omnibus positive auxiliaire et la barre omnibus positive auxiliaire.

De façon optionnelle également, le module bornier comporte en outre un troisième condensateur connecté entre la barre omnibus positive auxiliaire et la barre omnibus négative auxiliaire.

De façon optionnelle également, le module bornier comporte en outre :
- un quatrième condensateur connecté entre à la barre omnibus positive auxiliaire et une pièce conductrice destinée à être connectée à la masse électrique,
- un cinquième condensateur connecté entre la barre omnibus négative auxiliaire et un pièce conductrice destinée à être connectée à la masse électrique.

De façon optionnelle également, les pièces conductrices sont des pattes conductrices de fixation destinées à être fixées à la masse électrique.

Il est également proposé un convertisseur de tension comportant un ensemble d'un module principal et d'un module bornier selon l'invention, le module bornier étant assemblé au module principal en connectant la barre omnibus positive auxiliaire à la barre omnibus positive principale et la barre omnibus négative auxiliaire à la barre omnibus négative principale.

En d'autres termes le convertisseur de tension comporte un module principal et un module bornier formant un ensemble selon l'invention, ledit module bornier étant assemblé audit module principal par connexion de la barre omnibus positive auxiliaire à la barre omnibus positive principale et par connexion de la barre omnibus négative auxiliaire à la barre omnibus négative principale.

De façon optionnelle, le module bornier de ce convertisseur de tension comporte en outre :
- un quatrième condensateur connecté entre à la barre omnibus positive auxiliaire et une pièce conductrice connectée à la masse électrique,
- un cinquième condensateur connecté entre la barre omnibus négative auxiliaire et une pièce conductrice connectée à la masse électrique.

De façon optionnelle également lesdites pièces conductrices sont des pattes de fixation fixées à la masse électrique (302).

Il est également proposé un procédé de fabrication d'un convertisseur de tension comportant un ensemble d'un module principal et d'un module bornier selon l'invention, ledit procédé comportant :
- l'obtention d'un module principal comportant :
   - une barre omnibus positive principale,
   - une barre omnibus négative principale,
   - au moins une barre omnibus de phase destinée à être connectée à une phase respective d'une machine électrique,
   - pour chaque barre omnibus de phase :
      - un interrupteur de côté haut connecté entre la barre omnibus positive principale et la barre omnibus de phase,
      - un interrupteur de côté bas connecté entre la barre omnibus de phase et la barre omnibus négative principale,
   - une masse électrique,
   - un premier condensateur connecté entre à la barre omnibus positive principale et la masse électrique,
   - un deuxième condensateur connecté entre la barre omnibus négative principale et la masse électrique,
- l'obtention d'un module bornier comportant :
   - une barre omnibus positive auxiliaire présentant une borne positive,
   - une barre omnibus négative auxiliaire présentant une borne négative,
- l'assemblage du module bornier au module principal, cet assemblage comportant la connexion de la barre omnibus positive auxiliaire à la barre omnibus positive principale et de la barre omnibus négative auxiliaire fixée à la barre omnibus négative principale.

### DESCRIPTION DES FIGURES

La figure 1 est un schéma électrique d'un système électrique comportant un convertisseur de tension mettant en oeuvre l'invention et obtenu par l'assemblage d'un module principal et d'un module bornier.
La figure 2 est une vue en trois dimensions du convertisseur de tension de la figure 1, où un dissipateur de chaleur et des condensateurs de filtrage du module principal ont été omis.
La figure 3 est une vue similaire à la figure 2, avec le dissipateur de chaleur et les condensateurs de filtrage du module principal.
La figure 4 est une vue en trois dimensions d'un module bornier du convertisseur de tension des figures 1 à 3.
La figure 5 illustre les étapes d'un procédé de fabrication du convertisseur de tension.

### DESCRIPTION DÉTAILLÉE

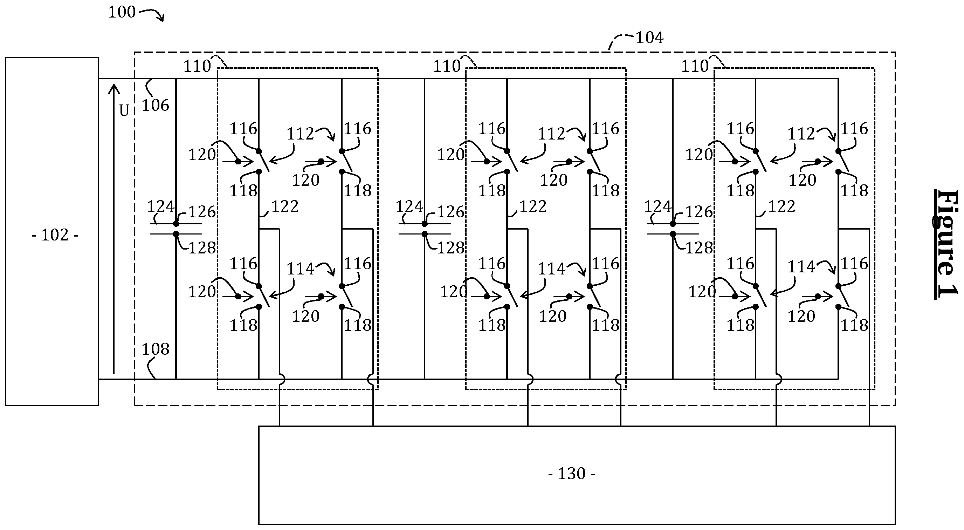

En référence à la figure 1, un système électrique 100 mettant en oeuvre l'invention va à présent être décrit.

Le système électrique 100 est par exemple destiné à être implanté dans un véhicule automobile.

Le système électrique 100 comporte tout d'abord une source d'alimentation électrique 102 conçue pour délivrer une tension continue U, par exemple comprise entre 20 V et 100 V, par exemple 48 V. La source d'alimentation électrique 102 comporte par exemple une batterie.

Le système électrique 100 comporte en outre une machine électrique 130 comportant plusieurs phases (non représentées) destinées à présenter des tensions de phase respectives.

Le système électrique 100 comporte en outre un convertisseur de tension 104 connecté entre la source d'alimentation électrique 102 et la machine électrique 130 pour effectuer une conversion entre la tension continue U et les tensions de phase.

Le convertisseur de tension 104 comporte tout d'abord une barre omnibus positive 106 et une barre omnibus négative 108 destinées à être connectées à la source d'alimentation électrique 102 pour recevoir la tension continue U, la barre omnibus positive 106 recevant un potentiel électrique haut et la barre omnibus négative 108 recevant un potentiel électrique bas.

Le convertisseur de tension 104 comporte en outre au moins un module de puissance 110 comportant une ou plusieurs barres omnibus de phase 122 destinées être respectivement connectées à une ou plusieurs phases de la machine électrique 130, pour fournir leurs tensions de phase respectives.

Dans l'exemple décrit, le convertisseur de tension 104 comporte trois modules de puissance 110 comportant chacun deux barres omnibus de phase 122 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières barres omnibus de phase 122 des modules de puissance 110 sont respectivement connectées aux trois phases du premier système triphasé, tandis que les deuxièmes barres omnibus de phase 122 des modules de puissance 110 sont respectivement connectées aux trois phases du deuxième système triphasé.

Chaque module de puissance 110 comporte, pour chaque barre omnibus de phase 122, un interrupteur de côté haut 112 connecté entre la barre omnibus positive 106 et la barre omnibus de phase 122 et un interrupteur de côté bas 114 connecté entre la barre omnibus de phase 122 et la barre omnibus négative 108. Ainsi, les interrupteurs 112, 114 sont agencés de manière à former un bras de hachage, dans lequel la barre omnibus de phase 122 forme un point milieu.

Chaque interrupteur 112, 114 comporte des première et deuxième bornes principales 116, 118 et une borne de commande 120 destinée à sélectivement ouvrir et fermer l'interrupteur 112, 114 entre ses deux bornes principales 116, 118 en fonction d'un signal de commande qui lui est appliqué. Les interrupteurs 112, 114 sont de préférence des transistors, par exemple des transistors à effet de champ à structure métal-oxyde-semiconducteur (de l'anglais « Métal Oxide Semiconductor Field Effect Transistor » ou MOSFET) présentant une grille formant la borne de commande 120, et un drain et une source formant respectivement les bornes principales 116, 118.

Dans l'exemple décrit, les interrupteurs 112, 114 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. En outre, la face inférieure forme une face de dissipation de chaleur.

Le convertisseur de tension 104 comporte en outre, pour chaque module de puissance 110, un condensateur 124 présentant une borne positive 126 et une borne négative 128 respectivement connectées à la barre omnibus positive 106 et à la barre omnibus négative 108.

Il sera apprécié que la barre omnibus positive 106, la barre omnibus négative 108 et les barres omnibus de phase 122 sont des éléments rigides conçus pour supporter des courants électriques d'au moins 1 A. Elles présentent de préférence une épaisseur d'au moins 1 mm.

En outre, dans l'exemple décrit, la machine électrique 130 a à la fois une fonction d'alternateur et de moteur électrique. Plus précisément, le véhicule automobile comporte en outre un moteur thermique (non représenté) présentant un axe de sortie auquel la machine électrique 130 est reliée par une courroie (non représentée). Le moteur thermique est destiné à entraîner des roues du véhicule automobile par l'intermédiaire de son axe de sortie. Ainsi, en fonctionnement comme alternateur, la machine électrique fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

Dans la suite de la description, la structure et la disposition des éléments d'un module de puissance 110 vont être décrits plus en détails, en référence à une direction verticale H-B, « H » représentant le haut et « B » représentant le bas.

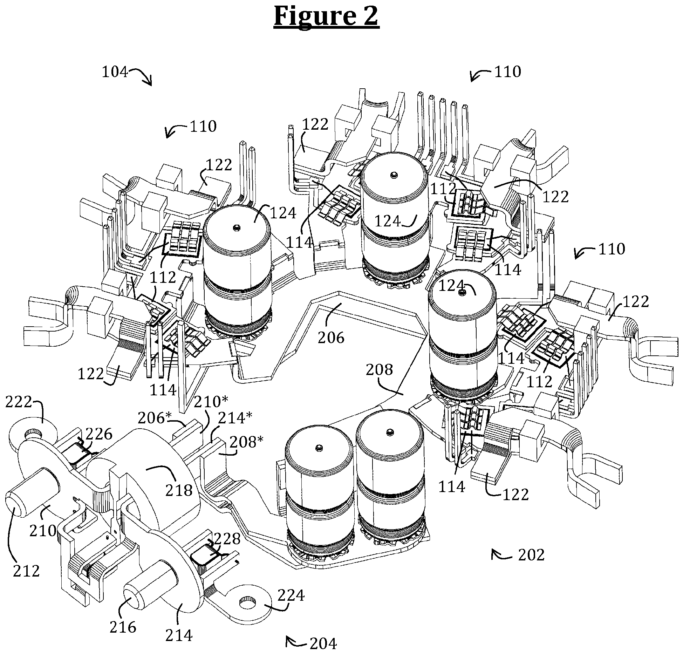

En référence à la figure 2, le convertisseur de tension 104 comporte un module principal 202 et un module bornier 204.

Le module principal 202 comporte les trois modules de puissance 110, ainsi qu'une barre omnibus positive principale 206 (faisant partie de la barre omnibus positive 106) et une barre omnibus négative principale 208 (faisant partie de la barre omnibus négative 108) passant par les modules de puissance 110 pour être connectées aux interrupteurs 112, 114 comme illustré sur la figure 1. Les barres omnibus principales 206, 208 comportent respectivement des extrémités de connexion 206*, 208*.

Le module bornier 204 comporte une barre omnibus positive auxiliaire 210 munie d'une borne positive 212 et une barre omnibus négative auxiliaire 214 présentant une borne négative 216. Les barres omnibus auxiliaires 210, 214 comportent respectivement des extrémités de connexion 210*, 214*, respectivement connectées aux extrémités de connexion 206*, 208* des barres omnibus principales 206, 208, par exemple par soudure, brasage ou vissage, afin d'établir une conduction électrique entre les barres omnibus auxiliaires 210, 214 et respectivement les barres omnibus principales 206, 208.

Les barres omnibus positives principale et auxiliaire 206, 210 font partie de la barre omnibus positive 106 représentée sur la figure 1, tandis que les barres omnibus négatives principale et auxiliaire 208, 214 font partie de la barre omnibus négative 108 représentée sur la figure 1.

Le module bornier 204 comporte en outre un tore magnétique 218 entourant les barres omnibus auxiliaires 210, 214.

Le module bornier 204 comporte en outre deux pattes de fixation 222, 224 conductrices.

Le module bornier 204 comporte en outre une première paire de condensateurs de filtrage 226, 228 en montage de type Y, c'est-à-dire destinés à être respectivement connectés entre les barres omnibus positive 106 et négative 108 et une masse électrique. Dans l'exemple décrit, les condensateurs de filtrage 226, 228 sont connectés entre, d'une part, respectivement les barres omnibus auxiliaires 210, 214 et, d'autre part, respectivement les deux pattes de fixation 222, 224 destinée à être connectées à la masse électrique, comme cela sera décrit par suite. Les condensateurs de filtrage 226, 228 sont situés, le long des barres omnibus auxiliaires 210, 214, entre les bornes positive et négative 212, 216 et le tore magnétique 218.

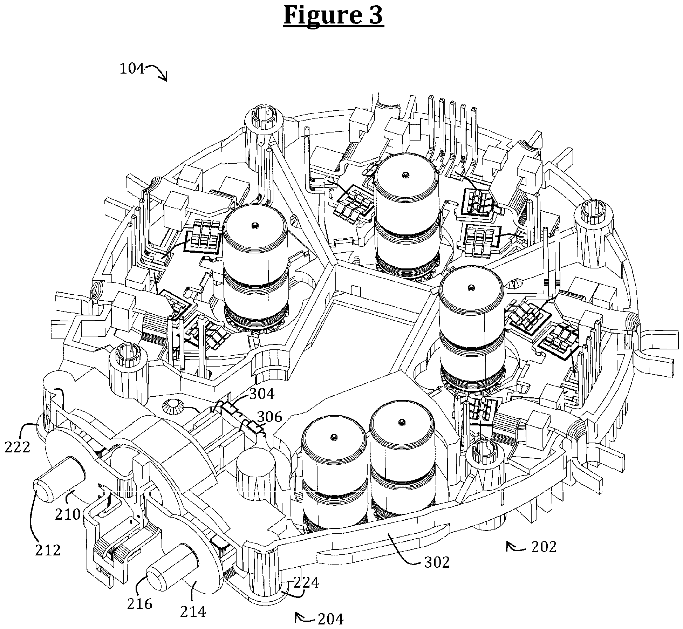

En référence à la figure 3, le module principal 202 comporte en outre un dissipateur de chaleur 302 conçu en particulier pour dissiper la chaleur générée par les interrupteurs 112, 114. Le dissipateur de chaleur 302 sert en outre de masse électrique.

Les pattes de fixation 222, 224 sont conçues pour être fixées au dissipateur de chaleur 302 afin de fixer mécaniquement le module auxiliaire 204 au module principal 202 et en outre pour connecter électriquement les condensateurs de filtrage 226, 228 à la masse électrique. Dans l'exemple décrit, les pattes de fixations 222, 224 sont munies d'une ouverture de passage de vis afin d'être vissées sur le dissipateur de chaleur 302.

Le module principal 202 comporte en outre une deuxième paire de condensateurs de filtrage 304, 306 en montage de type Y connectés entre, d'une part, respectivement les barres omnibus principales 206, 208 et, d'autre part, le dissipateur de chaleur 302.

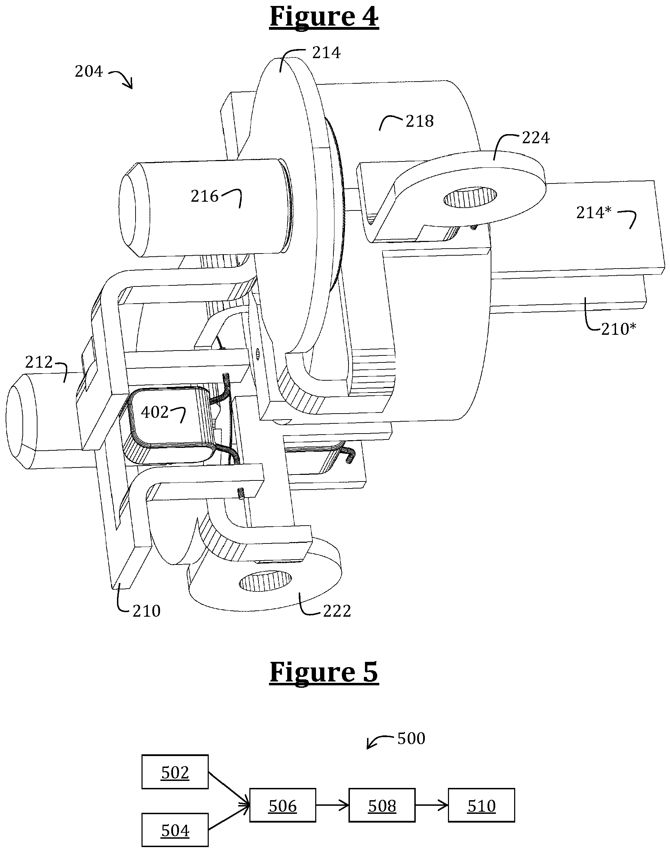

En référence à la figure 4, le module bornier 204 comporte en outre un condensateur de filtrage 402 en montage de type X, c'est-à-dire destiné à être connecté entre les deux barres omnibus positive 106 et négative 108. Dans l'exemple décrit, le condensateur de filtrage 402 est connecté entre les barres omnibus auxiliaires 210, 214.

De préférence, les condensateurs de filtrage 226, 228, 304, 306, 402 sont des condensateurs céramiques ou des condensateurs film.

Les condensateurs de filtrage 226, 228, 304, 306, 402 et le tore magnétique 218 permettent d'atteindre une compatibilité électromagnétique de classe 5 (selon la norme CISPR25).

Si une compatibilité magnétique de classe inférieure est nécessaire, il suffit de ne pas installer sur le module bornier l'un ou plusieurs des éléments suivants : le tore magnétique 218, les condensateurs de filtrage 226, 228 et le condensateur de filtrage 402.

Même en l'absence des éléments précédents, les condensateurs de filtrage 304, 306 restant sur le module principal 202 permettent d'obtenir une comptabilité électrique minimale, par exemple de classe 0/1 (selon la norme CISPR25).

En référence à la figure 5, un procédé 500 de fabrication du convertisseur de tension 104 va à présent être décrit.

Au cours d'une étape 502, le module principal 202 est obtenu.

Au cours d'une étape 504, le module auxiliaire 204 est obtenu.

Au cours d'une étape 506, le module auxiliaire 204 est mis en place contre le module principal 202, de sorte que, d'une part, les extrémités de connexion 210*, 214* des barres omnibus auxiliaires 210, 214 soient respectivement plaquées contre les extrémités de connexion 206*, 208* des barres omnibus principales 206, 208 et, d'autre part, que les pattes de fixation 222, 224 soient plaquées contre le dissipateur de chaleur 302.

Au cours d'une étape 508, les pattes de fixation 222, 224 sont fixées mécaniquement au dissipateur de chaleur 302, de manière à en outre établir une connexion électrique. Dans l'exemple décrit, elles sont fixées par vissage.

Au cours d'une étape 510, les extrémités de connexion 210*, 214* des barres omnibus auxiliaires 210, 214 sont respectivement connectées électriquement aux extrémités de connexion 206*, 208* des barres omnibus principales 206, 208, par exemple par soudure, brasage ou vissage.

La présente invention n'est pas limitée au mode de réalisation décrit précédemment, mais est au contraire définie par les revendications qui suivent. Il sera en effet apparent à l'homme du métier que des modifications peuvent y être apportées.

Par ailleurs, les termes utilisés dans les revendications ne doivent pas être compris comme limités aux éléments du mode de réalisation décrit précédemment, mais doivent au contraire être compris comme couvrant tous les éléments équivalents que l'homme du métier peut déduire à partir de ses connaissances générales.

## Revendications

1. Ensemble d'un module principal (202) et d'un module bornier (204) destinés à être assemblés l'un à l'autre, le module principal (202) comportant :
- une barre omnibus positive principale (206),
- une barre omnibus négative principale (208),
- au moins une barre omnibus de phase (122) destinée à être connectée à une phase respective d'une machine électrique (130),
- pour chaque barre omnibus de phase (122) :
- un interrupteur de côté haut (112) connecté entre la barre omnibus positive principale (206) et la barre omnibus de phase (122),
- un interrupteur de côté bas (114) connecté entre la barre omnibus de phase (122) et la barre omnibus négative principale (208),
- une masse électrique (302),
- un premier condensateur (304) connecté entre à la barre omnibus positive principale (206) et la masse électrique (302),
- un deuxième condensateur (306) connecté entre la barre omnibus négative principale (208) et la masse électrique (302),
et le module bornier (204) comportant :
- une barre omnibus positive auxiliaire (210) présentant une borne positive (212), la barre omnibus positive auxiliaire (210) étant destinée à être connectée à la barre omnibus positive principale (206) lors de l'assemblage du module bornier (204) au module principal (202),
- une barre omnibus négative auxiliaire (214) présentant une borne négative (216), la barre omnibus négative auxiliaire (214) étant destinée à être connectée à la barre omnibus négative principale (208) lors de l'assemblage du module bornier (204) au module principal (202).

2. Ensemble selon la revendication 1, dans lequel le module bornier (204) comporte en outre un tore magnétique (218) entourant la barre omnibus positive auxiliaire (210) et la barre omnibus négative auxiliaire (214).

3. Ensemble selon la revendication 1 ou 2, dans lequel le module bornier (204) comporte en outre un troisième condensateur (402) connecté entre la barre omnibus positive auxiliaire (210) et la barre omnibus négative auxiliaire (214).

4. Ensemble selon l'une quelconque des revendications 1 à 3, dans lequel le module bornier (204) comporte en outre :
- un quatrième condensateur (226) connecté entre à la barre omnibus positive auxiliaire (210) et une pièce conductrice (222) destinée à être connectée à la masse électrique (302),
- un cinquième condensateur (228) connecté entre la barre omnibus négative auxiliaire (214) et un pièce conductrice (224) destinée à être connectée à la masse électrique (302).

5. Ensemble selon la revendication 4, dans lequel les pièces conductrices (222, 224) sont des pattes de fixation (222, 224) destinées à être fixées à la masse électrique (302).

6. Convertisseur de tension (104) comportant un ensemble selon l'une des revendications 1 à 3, le module bornier (204) étant assemblé au module principal (202) par connexion de la barre omnibus positive auxiliaire (210) à la barre omnibus positive principale (206) et par connexion de la barre omnibus négative auxiliaire (214) à la barre omnibus négative principale (208).

7. Convertisseur de tension (104) selon la revendication 6 dans lequel le module bornier (204) comporte en outre :
- un quatrième condensateur (226) connecté entre à la barre omnibus positive auxiliaire (210) et une pièce conductrice (222) connectée à la masse électrique (302),
- un cinquième condensateur (228) connecté entre la barre omnibus négative auxiliaire (214) et une pièce conductrice (224) connectée à la masse électrique (302).

8. Convertisseur de tension (104) selon la revendication 7 dans lequel les pièces conductrices (222, 224) sont des pattes de fixation (222, 224) fixées à la masse électrique (302).

9. Procédé de fabrication d'un convertisseur de tension (104) selon l'une quelconque des revendications 6 à 8, comportant :
- l'obtention d'un module principal (202) comportant :
- une barre omnibus positive principale (206),
- une barre omnibus négative principale (208),
- au moins une barre omnibus de phase (122) destinée à être connectée à une phase respective d'une machine électrique (130),
- pour chaque barre omnibus de phase (122) :
- un interrupteur de côté haut (112) connecté entre la barre omnibus positive principale (206) et la barre omnibus de phase (122),
- un interrupteur de côté bas (114) connecté entre la barre omnibus de phase (122) et la barre omnibus négative principale (208),
- une masse électrique (302),
- un premier condensateur (304) connecté entre à la barre omnibus positive principale (206) et la masse électrique (302),
- un deuxième condensateur (306) connecté entre la barre omnibus négative principale (208) et la masse électrique (302),
- l'obtention d'un module bornier (204) comportant :
- une barre omnibus positive auxiliaire (210) présentant une borne positive (212),
- une barre omnibus négative auxiliaire (214) présentant une borne négative (216),
- l'assemblage du module bornier (204) au module principal (202), cet assemblage comportant la connexion de la barre omnibus positive auxiliaire (210) à la barre omnibus positive principale (206) et de la barre omnibus négative auxiliaire (214) à la barre omnibus négative principale (208).

## Patentansprüche

1. Einheit aus einem Hauptmodul (202) und einem Klemmenleistenmodul (204), die dazu bestimmt sind, miteinander verbunden zu werden, wobei das Hauptmodul (202) aufweist:
- eine positive Hauptsammelschiene (206),
- eine negative Hauptsammelschiene (208),
- mindestens eine Phasen-Sammelschiene (122), die dazu bestimmt ist, an eine jeweilige Phase einer elektrischen Maschine (130) angeschlossen zu werden,
- für jede Phasen-Sammelschiene (122):
- einen High-Side-Schalter (112), der zwischen der positiven Hauptsammelschiene (206) und der Phasen-Sammelschiene (122) angeschlossen ist,
- einen Low-Side-Schalter (114), der zwischen der Phasen-Sammelschiene (122) und der negativen Hauptsammelschiene (208) angeschlossen ist,
- eine elektrische Masse (302),
- einen ersten Kondensator (304), der zwischen der positiven Hauptsammelschiene (206) und der elektrischen Masse (302) angeschlossen ist,
- einen zweiten Kondensator (306), der zwischen der negativen Hauptsammelschiene (208) und der elektrischen Masse (302) angeschlossen ist,
und das Klemmenleistenmodul (204) aufweist:
- eine positive Hilfssammelschiene (210), die eine positive Klemme (212) aufweist, wobei die positive Hilfssammelschiene (210) dazu bestimmt ist, beim Verbinden des Klemmenleistenmoduls (204) mit dem Hauptmodul (202) an die positive Hauptsammelschiene (206) angeschlossen zu werden,
- eine negative Hilfssammelschiene (214), die eine negative Klemme (216) aufweist, wobei die negative Hilfssammelschiene (214) dazu bestimmt ist, beim Verbinden des Klemmenleistenmoduls (204) mit dem Hauptmodul (202) an die negative Hauptsammelschiene (208) angeschlossen zu werden.

2. Einheit nach Anspruch 1, wobei das Klemmenleistenmodul (204) außerdem einen Magnetkern (218) aufweist, der die positive Hilfssammelschiene (210) und die negative Hilfssammelschiene (214) umgibt.

3. Einheit nach Anspruch 1 oder 2, wobei das Klemmenleistenmodul (204) außerdem einen dritten Kondensator (402) aufweist, der zwischen der positiven Hilfssammelschiene (210) und der negativen Hilfssammelschiene (214) angeschlossen ist.

4. Einheit nach einem der Ansprüche 1 bis 3, wobei das Klemmenleistenmodul (204) außerdem aufweist:
- einen vierten Kondensator (226), der zwischen der positiven Hilfssammelschiene (210) und einem leitenden Bauteil (222) angeschlossen ist, das dazu bestimmt ist, an die elektrische Masse (302) angeschlossen zu werden,
- einen fünften Kondensator (228), der zwischen der negativen Hilfssammelschiene (214) und einem leitenden Bauteil (224) angeschlossen ist, das dazu bestimmt ist, an die elektrische Masse (302) angeschlossen zu werden.

5. Einheit nach Anspruch 4, wobei die leitenden Bauteile (222, 224) Befestigungslaschen (222, 224) sind, die dazu bestimmt sind, an der elektrischen Masse (302) befestigt zu werden.

6. Spannungswandler (104), der eine Einheit nach einem der Ansprüche 1 bis 3 aufweist, wobei das Klemmenleistenmodul (204) mit dem Hauptmodul (202) durch Anschluss der positiven Hilfssammelschiene (210) an die positive Hauptsammelschiene (206) und durch Anschluss der negativen Hilfssammelschiene (214) an die negative Hauptsammelschiene (208) verbunden wird.

7. Spannungswandler (104) nach Anspruch 6, wobei das Klemmenleistenmodul (204) außerdem aufweist:
- einen vierten Kondensator (226), der zwischen der positiven Hilfssammelschiene (210) und einem an die elektrische Masse (302) angeschlossenen leitenden Bauteil (222) angeschlossen ist,
- einen fünften Kondensator (228), der zwischen der negativen Hilfssammelschiene (214) und einem an die elektrische Masse (302) angeschlossenen leitenden Bauteil (224) angeschlossen ist.

8. Spannungswandler (104) nach Anspruch 7, wobei die leitenden Bauteile (222, 224) an der elektrischen Masse (302) befestigte Befestigungslaschen (222, 224) sind.

9. Verfahren zur Herstellung eines Spannungswandlers (104) nach einem der Ansprüche 6 bis 8, das aufweist:
- den Erhalt eines Hauptmoduls (202), das aufweist:
- eine positive Hauptsammelschiene (206),
- eine negative Hauptsammelschiene (208),
- mindestens eine Phasen-Sammelschiene (122), die dazu bestimmt ist, an eine jeweilige Phase einer elektrischen Maschine (130) angeschlossen zu werden,
- für jede Phasen-Sammelschiene (122):
- einen High-Side-Schalter (112), der zwischen der positiven Hauptsammelschiene (206) und der Phasen-Sammelschiene (122) angeschlossen ist,
- einen Low-Side-Schalter (114), der zwischen der Phasen-Sammelschiene (122) und der negativen Hauptsammelschiene (208) angeschlossen ist,
- eine elektrische Masse (302),
- einen ersten Kondensator (304), der zwischen der positiven Hauptsammelschiene (206) und der elektrischen Masse (302) angeschlossen ist,
- einen zweiten Kondensator (306), der zwischen der negativen Hauptsammelschiene (208) und der elektrischen Masse (302) angeschlossen ist,
- den Erhalt eines Klemmenleistenmoduls (204), das aufweist:
- eine positive Hilfssammelschiene (210), die eine positive Klemme (212) aufweist,
- eine negative Hilfssammelschiene (214), die eine negative Klemme (216) aufweist,
- die Verbindung des Klemmenleistenmoduls (204) mit dem Hauptmodul (202), wobei diese Verbindung den Anschluss der positiven Hilfssammelschiene (210) an die positive Hauptsammelschiene (206) und der befestigten negativen Hilfssammelschiene (214) an die negative Hauptsammelschiene (208) aufweist.

## Claims

1. Assembly of a main module (202) and of a terminal block module (204) that are intended to be joined with one another, the main module (202) including:
- a main positive busbar (206),
- a main negative busbar (208),
- at least one phase busbar (122) intended to be connected to a respective phase of an electrical machine (130),
- for each phase busbar (122):
- a high-side switch (112) connected between the main positive busbar (206) and the phase busbar (122),
- a low-side switch (114) connected between the phase busbar (122) and the main negative busbar (208),
- an electrical ground (302),
- a first capacitor (304) connected between the main positive busbar (206) and the electrical ground (302),
- a second capacitor (306) connected between the main negative busbar (208) and the electrical ground (302),
and the terminal block module (204) including:
- an auxiliary positive busbar (210) having a positive terminal (212), the auxiliary positive busbar (210) being intended to be connected to the main positive busbar (206) when the terminal block module (204) is joined with the main module (202),
- an auxiliary negative busbar (214) having a negative terminal (216), the auxiliary negative busbar (214) being intended to be connected to the main negative busbar (208) when the terminal block module (204) is joined with the main module (202).

2. Assembly according to Claim 1, wherein the terminal block module (204) further includes a magnetic core (218) surrounding the auxiliary positive busbar (210) and the auxiliary negative busbar (214).

3. Assembly according to Claim 1 or 2, wherein the terminal block module (204) further includes a third capacitor (402) connected between the auxiliary positive busbar (210) and the auxiliary negative busbar (214).

4. Assembly according to any one of Claims 1 to 3, wherein the terminal block module (204) further includes:
- a fourth capacitor (226) connected between the auxiliary positive busbar (210) and a conductive part (222) intended to be connected to the electrical ground (302),
- a fifth capacitor (228) connected between the auxiliary negative busbar (214) and a conductive part (224) intended to be connected to the electrical ground (302).

5. Assembly according to Claim 4, wherein the conductive parts (222, 224) are fixing lugs (222, 224) intended to be fixed to the electrical ground (302).

6. Voltage converter (104) which includes an assembly according to one of Claims 1 to 3, the terminal block module (204) being joined with the main module (202) by connecting the auxiliary positive busbar (210) to the main positive busbar (206) and by connecting the auxiliary negative busbar (214) to the main negative busbar (208).

7. Voltage converter (104) according to Claim 6, wherein the terminal block module (204) further includes:
- a fourth capacitor (226) connected between the auxiliary positive busbar (210) and a conductive part (222) connected to the electrical ground (302),
- a fifth capacitor (228) connected between the auxiliary negative busbar (214) and a conductive part (224) connected to the electrical ground (302) .

8. Voltage converter (104) according to Claim 7, wherein the conductive parts (222, 224) are fixing lugs (222, 224) fixed to the electrical ground (302).

9. Method for manufacturing a voltage converter (104) according to any one of Claims 6 to 8, including:
- obtaining a main module (202) including:
- a main positive busbar (206),
- a main negative busbar (208),
- at least one phase busbar (122) intended to be connected to a respective phase of an electrical machine (130),
- for each phase busbar (122):
- a high-side switch (112) connected between the main positive busbar (206) and the phase busbar (122),
- a low-side switch (114) connected between the phase busbar (122) and the main negative busbar (208),
- an electrical ground (302),
- a first capacitor (304) connected between the main positive busbar (206) and the electrical ground (302),
- a second capacitor (306) connected between the main negative busbar (208) and the electrical ground (302),
- obtaining a terminal block module (204) including:
- an auxiliary positive busbar (210) having a positive terminal (212),
- an auxiliary negative busbar (214) having a negative terminal (216),
- joining the terminal block module (204) with the main module (202), this joining including connecting the auxiliary positive busbar (210) to the main positive busbar (206) and the auxiliary negative busbar (214) to the main negative busbar (208).
